# EUROPEAN PATENT SPECIFICATION

(11) **EP 1 881 392 B1**
(45) Date of publication and mention of the grant of the patent: **29.04.2009**
(21) Application number: 07104434.1
(22) Date of filing: 07.10.2005
(51) Int. Cl.: G06F 1/16, H01M 2/10, H04B 1/38, H04M 1/02, H05K 5/00

(54) **Versatile battery compartment for hand-held devices**
Vielseitiges Batteriefach für tragbare Vorrichtungen
Compartiment de batterie polyvalent pour dispositifs portatifs

(43) Date of publication of application: 23.01.2008
(62) Divisional of application: 05109309.4
(73) Proprietor: Research In Motion Limited, Waterloo, Ontario N2L 3W8 (CA)
(72) Inventor: Ladouceur, Norman, Waterloo, Ontario N2T 1A2 (CA); Griffin, Jason, Waterloo, Ontario N2T 2J5 (CA); Tyneski, Frank, Solana Beach, CA 92075 (US)
(74) Representative: Rickard, David John

(56) References cited:
- EP-A- 1 603 246
- US-A- 6 048 642

## Description

This invention relates generally to portable electronic devices, including but not limited to handheld wireless communication devices. More particularly, this invention relates to means of accommodating batteries of different sizes in such devices.

Certain portable electronic devices, handheld wireless communication devices in particular, are designed to provide various battery life options, depending on different capacity batteries being used. Batteries of different capacity tend to have different physical dimensions. These differences in dimension are typically compensated for by providing battery area access doors of varying dimension, i.e. a separate battery door for each possible battery. It would be preferable to avoid such separate battery doors.

US-A-6048642 discloses a portable electronic device having a battery compartment with a removable cover able to slide relative to the battery compartment to accommodate batteries of different thickness.

EP-A-1603246 is late published, thus falling under the provision of Article 54(3)EPC ; it discloses a portable electronic device having a battery compartment with a removable cover.

The invention therefore preferably provides various means for accommodating batteries of different dimensions, without requiring separate battery doors.

Reference will be made to "relatively thin" batteries, and "somewhat thicker" batteries. It should be understood that "relatively thin" means relative to the thickness of the "somewhat thicker" batteries, and is not intended to indicate that the "relatively thin" battery is in fact thin compared to batteries in general.

This invention provides a portable electronic device having a battery compartment and a removable cover therefor, the portable electronic device having said battery compartment and cover configured to engage each other in one of at least two discrete relative positions, each said position providing a different battery compartment depth to accommodate batteries of different sizes; and wherein said battery cover has an outer surface and side walls configured to encompass an installed battery, wherein said side walls have engagement means extending outwardly therefrom to engage recesses in side walls of said battery compartment or said battery compartment has flexible engagement means extending inwardly therefrom to engage recesses in said battery cover side walls, said recesses being provided at at least two relative heights.

The invention contemplates batteries not only of discrete sizes, but in at least some embodiments, sizes which may vary along a continuum of sizes.

Aspects of the invention will be described or will become apparent in the course of the following detailed description and drawings of specific embodiments of the invention, as examples only.

### BRIEF DESCRIPTION OF THE DRAWINGS

Embodiments of the invention will now be described, by way of example only, with reference to the attached drawings, in which:
Fig. 1 is an example of a handheld device that can accommodate batteries of two different sizes, shown with a relatively thin battery;
Fig. 2 is another perspective view of the example of figure 1, with a somewhat thicker battery;
Fig. 3 is a cross-sectional elevation view of the figure 1 example, with a relatively thin battery;
Fig. 4 is a cross-sectional elevation view of the figure 1 example, with a somewhat thicker battery;
Fig. 5 is a cross-sectional elevation view of a further example, similar to the example of figure 1, with a relatively thin battery;
Fig. 6 is a cross-sectional elevation view of the figure 5 example, with a somewhat thicker battery;
Fig. 7 is a cross-sectional elevation view of a further example, with a relatively thin battery;
Fig. 8 is a cross-sectional elevation view of a portion of the cover of the figure 7 device;
Fig. 9 is a cross-sectional elevation view of the figure 7 device, with a somewhat thicker battery;
Fig. 10 is a perspective view of the battery cover of a further example, in a position for a relatively thin battery;
Fig. 11 is a cross-sectional elevation view of the cover, corresponding to Fig. 10;
Fig. 12 is a perspective view of the battery cover of the figure 10 example, in a position for a somewhat thicker battery; and
Fig.13 is a cross-sectional elevation view of the cover, corresponding to Fig. 12.

### DESCRIPTION OF PREFERRED EMBODIMENTS

The accompanying drawings illustrate various aspects and exemplary embodiments to accommodate batteries of different sizes.

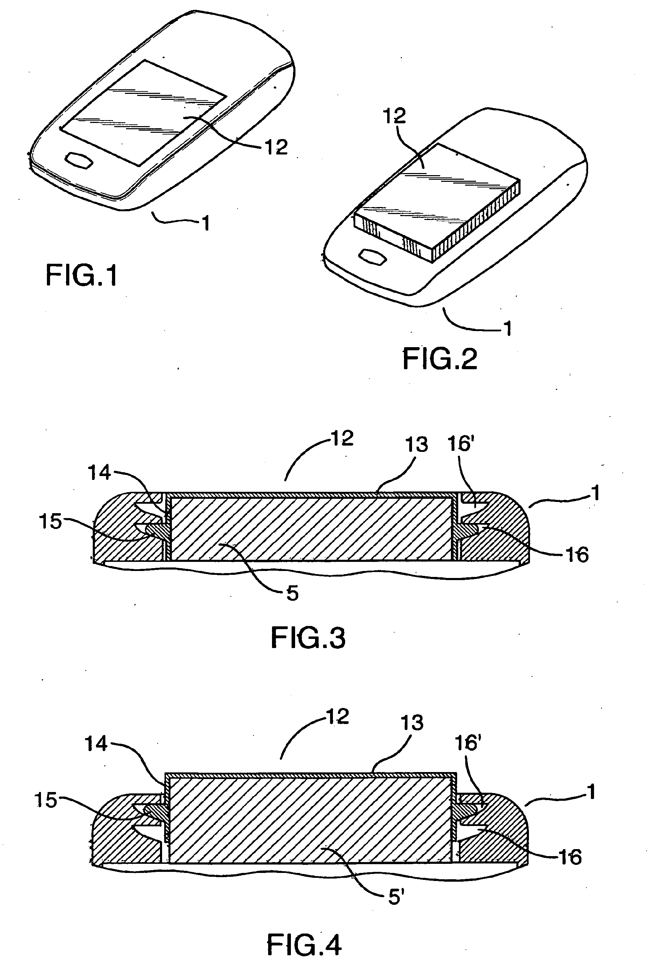

In the embodiment of the invention shown in figures 1 to 4, a battery cover **12** has an outer surface **13** and side walls **14** encompassing the battery **5** or **5'.** The battery cover preferably is generally rigid, but could be somewhat flexible. Extending outwardly from the side walls **14** are flexible engagement means **15** such as elastomeric or otherwise flexible tabs or a flange, which can engage corresponding recesses **16** or **16'** at two or more relative heights. The battery cover is installed by pressing it downwardly into the battery compartment, such that the flexible engagement means snap or pop into the relevant recess or recesses. One recess height, shown in Fig. 3, corresponds to a relatively thin battery **5,** while the other recess height, shown in Fig. 4, corresponds to a somewhat thicker battery **5'.** There could be additional recess heights if desired. The flexible engagement means **15** could be tabs placed at several locations around the circumference of the battery cover, with recesses at corresponding locations, or could be in the form of a continuous flange extending all the way around the battery cover. The tabs or flange could be integral to the battery cover, or could be a separate piece. Although elastomeric tabs or an elastomeric flange are primarily contemplated, it should be appreciated that analogous means could be employed instead. For example, the battery cover could be provided with a ball-spring arrangement, to engage detents at different heights in the battery compartment, or the reverse could be provided, i.e. ball-spring arrangements in the battery compartment, engaging detents in the side walls of the battery cover.

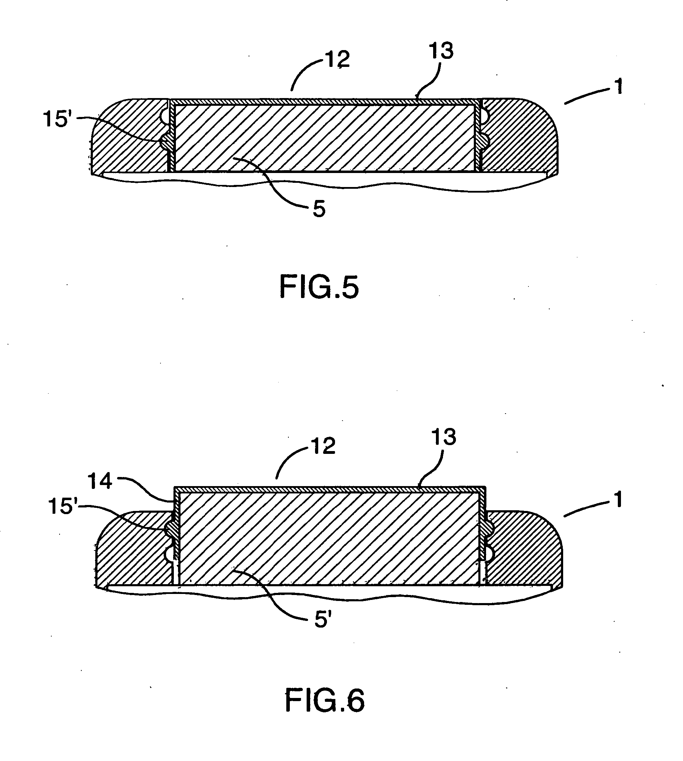

Figs. 5 and 6 show an embodiment, very similar to the preceding embodiment, in which the flexible engagement means **15** is in the form of elastomeric dimples engaging corresponding recesses. The ball-spring arrangement referred to above would be somewhat similar in concept and appearance.

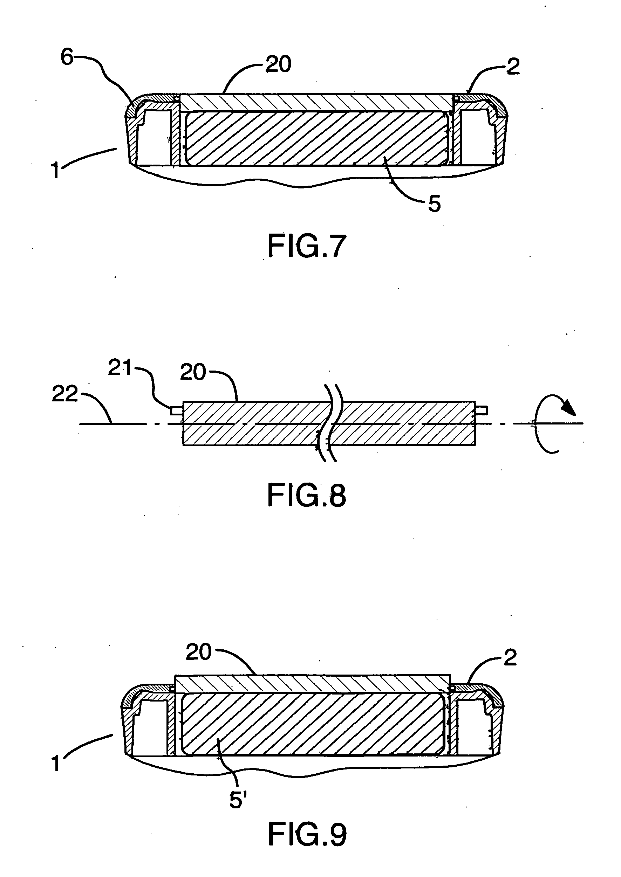

Figs. 7 to 9 show an exemplary embodiment, in which the battery cover **20** itself, or a portion thereof, is reversible and has tabs or flanges **21** displaced from the centreline **22.** As can be seen from comparing Figs. 7 and 9, flipping the cover or cover portion thus creates a smaller or larger space for the battery **5** or **5'.**

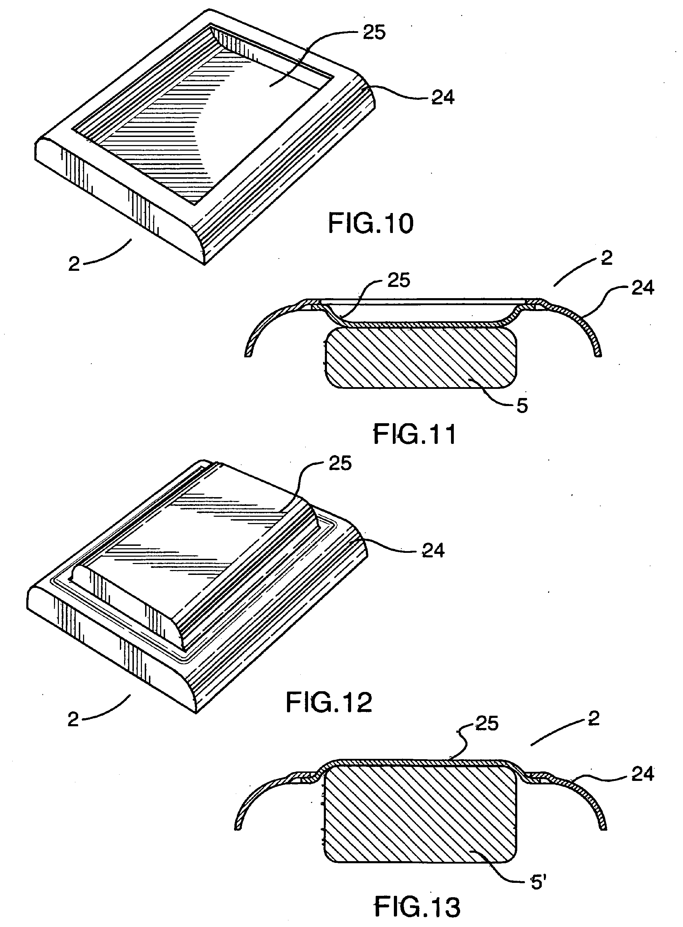

Figs. 10 to 13 show a further exemplary embodiment, in which the battery cover **2** is in two pieces, namely an outer frame **24,** and a central portion **25.** As can be readily seen from the drawings, the centre portion can be installed in one of two positions, according to a principle somewhat similar to the preceding embodiment. Depending on which orientation is used, a smaller or larger space for the battery **5** or **5'** is created.

The preceding embodiments illustrate various aspects of the invention, but as examples only. It will be appreciated that many additional variations and examples are possible, and will be apparent to those knowledgeable in the field of the invention. Thus the scope of the invention, as defined in the following claims, is not limited to these specific examples.

Without limiting the generality of the foregoing, further aspects may include, for example, any other obvious variations as to how the battery cover may be configured or installed to provide varying battery compartment sizes; any obvious variations in choices of materials, degree of flexibility or resilience, if any, and any obvious variations in size, shape or other characteristics not relevant to the point of the invention. It should also be noted that although certain of the exemplary embodiments above lend them selves to discrete battery sizes only, others (for example embodiments with elastomeric elements) may lend themselves to a variety of battery sizes, along a continuum).

A portion of the disclosure of this document contains material which is subject to copyright protection. The copyright owner has no objection to the facsimile reproduction by anyone of the patent document or disclosure, as it appears in the Patent Office file or public records, but otherwise reserves all copyright protection whatsoever.

## Claims

1. A portable electronic device (1) having a battery compartment (3) and a removable cover (2) therefor, the portable electronic device having said battery compartment (3) and cover (2) configured to engage each other in one of at least two discrete relative positions, each said position providing a different battery compartment depth to accommodate batteries (5, 5') of different sizes; and
wherein said battery cover (2) has an outer surface (13) and side walls (14) configured to encompass an installed battery, wherein said side walls have engagement means (15, 15') extending outwardly therefrom to engage recesses (16, 16') in side walls of said battery compartment or said battery compartment has flexible engagement means extending inwardly therefrom to engage recesses in said battery cover side walls, said recesses being provided at at least two relative heights.

2. The portable electronic device of claim 1, wherein said engagement means (15, 15') are flexible and are at a plurality of locations around said side walls.

3. The portable electronic device of claim 1, wherein said engagement means (15, 15') is a flexible flange extending around said side walls.

## Patentansprüche

1. Tragbares elektronisches Gerät (1) mit einem Batteriefach (3) und einer abnehmbaren Abdeckung (2) für dieses, wobei bei dem tragbaren elektronischen Gerät das Batteriefach (3) und die Abdeckung (2) so konfiguriert sind, dass sie in einer von mindestens zwei einzelnen relativen Positionen ineinander eingreifen, wobei jede Position für eine unterschiedliche Batteriefachtiefe sorgt, um unterschiedlich große Batterien (5, 5') aufzunehmen; und
wobei die Batterieabdeckung (2) eine Außenfläche (13) und Seitenwände (14) aufweist, die dafür konfiguriert sind, eine eingelegte Batterie zu umfassen, wobei die Seitenwände Eingriffmittel (15, 15') aufweisen, die von ihnen aus nach außen verlaufen, um in Aussparungen (16, 16') in den Seitenwänden des Batteriefachs einzugreifen, oder das Batteriefach flexible Eingriffmittel aufweist, die von diesem aus nach innen verlaufen, um in die Aussparungen in den Batteriefachseitenwänden einzugreifen, wobei diese Aussparungen in mindestens zwei relativen Höhen vorgesehen sind.

2. Tragbares elektronisches Gerät gemäß Anspruch 1, wobei die Eingriffmittel (15, 15') flexibel sind und sich an einer Mehrzahl von Stellen entlang der Seitenwände befinden.

3. Tragbares elektronisches Gerät gemäß Anspruch 1, wobei die Eingriffmittel (15, 15') ein flexibler Flansch sind, der sich entlang der Seitenwände erstreckt.

## Revendications

1. Un dispositif électronique portatif (1) ayant un compartiment de batterie (3) et un couvercle amovible (2) pour ce dernier, lesdits compartiment de batterie (3) et couvercle (2) du dispositif électronique portatif étant configurés pour se mettre en prise l'un avec l'autre dans une position parmi au moins deux positions relatives discrètes, chaque dite position fournissant une profondeur de compartiment de batterie différente pour loger des batteries (5, 5') de tailles différentes ; et
où ledit couvercle de batterie (2) a une surface externe (13) et des parois latérales (14) configurées pour contenir une batterie installée, où lesdites parois latérales ont des moyens de mise en prise (15, 15') s'étendant vers l'extérieur à partir de celles-ci pour se mettre en prise avec des creux (16, 16') dans les parois latérales dudit compartiment de batterie ou ledit compartiment de batterie a des moyens de mise en prise flexibles s'étendant vers l'intérieur à partir de celui-ci pour se mettre en prise avec des creux dans lesdites parois latérales de couvercle de batterie, lesdits creux étant fournis à au moins deux hauteurs relatives.

2. Le dispositif électronique portatif de la revendication 1, où lesdits moyens de mise en prise (15, 15') sont flexibles et sont à une pluralité d'endroits autour desdites parois latérales.

3. Le dispositif électronique portatif de la revendication 1, où lesdits moyens de mise en prise (15, 15') sont un flasque flexible s'étendant autour desdites parois latérales.
